# NEW EUROPEAN PATENT SPECIFICATION

(11) **EP 0 656 430 B2**
(45) Date of publication and mention of the opposition decision: **12.01.2000**
(45) Mention of the grant of the patent: 12.03.1997
(21) Application number: 93830451.6
(22) Date of filing: 09.11.1993
(51) Int. Cl.: C23C 14/10, C23C 14/54, C23C 14/56, B65D 65/40

(54) **Process and apparatus for the codeposition of metallic oxides on plastic films.**
Verfahren und Vorrichtung zur gleichzeitigen Beschichtung von Kunststoffsubstraten mit Metalloxyden
Procédé et appareil pour la codéposition des oxydes métalliques sur film plastiques

(43) Date of publication of application: 07.06.1995
(73) Proprietor: Galileo Vacuum Systems S.R.L., 59100 Prato (IT)
(72) Inventor: Fusi, Andrea, I-50136 Firenze (IT)
(74) Representative: Mannucci, Gianfranco, Dott.-Ing.

(56) References cited:
- EP-A- 0 460 796
- EP-A- 0 549 528
- DE-A- 4 113 221
- DE-B- 1 278 194
- GB-A- 2 119 970
- US-A- 5 107 791

## Description

The invention relates to a process for the production of a plastic film having a dielectric layer deposited by vacuum evaporation, and an apparatus for carrying out the said proces, according to the preamble of claims 1 and 7.

It is known that the deposition of a layer of dielectric material, in particular of a metallic oxide, on a plastic film, optionally in the presence of a metallic layer, imparts to the said film a high barrier effect, which renders it suitable for use in, for example, the food packaging sector.

The technique of vacuum deposition presents considerable problems from the point of view of the conditions of evaporation (in particular in respect of maintaining high levels of vacuum in the deposition chamber), from the point of view of the optical and aesthetic quality of the deposited layer, and from the point of view of the costs of the products employed for the deposition.

Currently, in order to obtain a product which provides a sufficient barrier to oxygen and to moisture and which at the same time has a transparent appearance, silicon monoxide is employed. This material has the disadvantage of being extremely expensive. Furthermore, the plastic film treated with silicon monoxide acquires a yellowish coloration.

Silicon dioxide involves much lower costs but the film obtained does not exhibit the desired barrier effect.

From EP-A-0 460 796 a method for producing a silicon oxide coating on plastic films is known wherein silicon dioxide is deposited under vacuum on a polymeric substrate. The SiO₂ coating is doped with a metal or an oxide. Doping is claimed to increase the barrier properties of the substrate.

EP-A-0 549 528 discloses a method for coating plastic film substrates, wherein two different oxides are evaporated from one and the same evaporating source. The result is a co-deposition of the two oxides on the substrate.

DE-A-4 113 221 discloses a polymeric film with coating of SiO₂ or more generally of SiOₓ wherein x is between 1,5 and 1,9. In the latter case the starting material is SiO.

A first object of the invention is that of proposing a process and an apparatus of vacuum deposition on a plastic film, in which there is obtained a barrier effect superior to that obtainable with the conventional techniques.

A further object of the present invention is that of providing a process and a corresponding apparatus which permit obtaining a plastic film with a deposit of oxides which has the properties of transparency and absence of colour required specifically for applications in the foodstuffs sector.

A further object of the present invention is the provision of a method and an apparatus which permit obtaining improved morphological structures of the oxide layer on the plastic film, in particular by controlling the pressure within the vacuum chamber.

These and other objects and advantages of the invention, which will appear clearly to those skilled in the art from reading the text which follows, are achieved with a process according to claim 1 and with an apparatus according to claim 7.

There exist metals which have the property, if evaporated in vacuo, of condensing whilst absorbing the residual gases, in particular of becoming oxidized while absorbing oxygen. This property is known by the name of getter effect. The invention is based on the concept of codepositing, on a substrate or plastic film and in a single vacuum chamber, a thin layer resulting from the coevaporation of an oxide, which tends to dissociate, liberating oxygen, and of a getter metal. The two evaporating materials condense on the substrate: the first material deposits in the form of a sub-oxide the second, which evaporates as a metal, deposits as an oxide by bonding to the oxygen liberated from the first material, jointly giving rise to a dielectric layer of mixed oxides.

This new method of codeposition makes it possible to achieve numerous advantages. Thus when using, for example, silicon dioxide as the oxide, the latter tends to dissociate, liberating oxygen. The oxygen liberated combines with the getter metal, for example magnesium. In this way there is deposited, on the plastic film, a layer of dielectric material consisting of the mixed oxides of magnesium and silicon, in which the silicon oxide has an optimum ratio of oxygen to silicon, in the region of about 1.5 oxygen atoms per silicon atom.

This layer of mixed oxides exhibits excellent barrier properties and excellent properties of transparency and absence of colour.

Furthermore, it is obtained starting from low cost materials, for silicon dioxide is vastly cheaper than silicon monoxide.

The use of a process of codeposition with getter metals furthermore provides other important advantages. Thus, the presence of the getter metal, which tends to absorb the oxygen liberated during the evaporation of the oxide, reduces the pressure in the deposition chamber and thus improves the quality of the deposited layer in that the latter is obtained with a higher molecular energy. This is due to the fact that the absorption of the oxygen by the getter metal reduces the number of collisions between the molecules originating from the oxide evaporation source and the oxygen molecules which would otherwise be free.

Furthermore, the formation of a mixed oxide layer rather than of an oxide of the same species, has advantages from the point of view of stability.

In order to avoid the getter metal depositing in a metallic form - for example due to the amount of oxygen liberated from the oxide of a first source being insufficient - it is possible to provide, according to an improved embodiment of the method according to the invention, the introduction of a controlled amount of oxygen into the deposition chamber. This makes it possible to achieve complete oxidation of the getter metal and hence to obtain the deposition of a layer consisting totally of mixed oxides, without a trace of free metals.

The process according to the invention can be carried out not only with silicon dioxide as the first material but also with other oxides which tend to release oxygen, for example alumina.

The metallic getter material which may be employed can be magnesium, aluminium, barium or another metal having equivalent properties and capable of forming an oxide suitable for the formation of a barrier on a plastic film.

According to a preferred embodiment of the method according to the invention, silicon dioxide is employed as the first material and magnesium as the second material.

The apparatus according to the invention, for carrying out the process described above, is characterized in that it comprises - in one and the same deposition chamber - a first source for the evaporation of a first material consisting of an oxide which tends to dissociate and a second source for the evaporation of a second material consisting of a metal having a getter effect.

Advantageously, the first source can be an electron gun, for example of the "PIERCE" type, as the temperatures required for the evaporation of the oxides employed in this sector are extremely high. The source for the evaporation of the getter metal can however also be a resistance crucible or other source at a relatively low temperature.

Advantageously, the apparatus can be combined with a source of oxygen for introducing, into the deposition chamber, controlled amounts of oxygen for the purposes explained above.

A further subject of the invention is a plastic film having a deposit of a thin layer of mixed oxides.

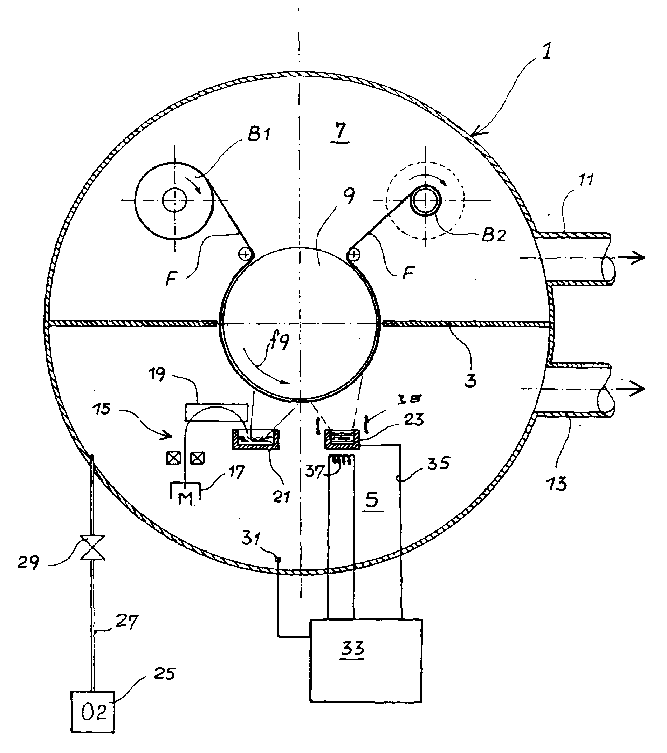

The attached figure shows, very schematically, a deposition chamber according to the invention, in cross-section.

Referring to the drawing, 1 generically indicates the chamber divided by a partition 3 into two half-chambers: the lower half-chamber marked 5 and in the text which follows simply referred to as the deposition chamber contains the evaporation sources. The upper chamber, marked 7, houses a reel B₁ from which the film F, onto which the deposition is to be effected, unwinds, and a reel B₂ onto which the film is wound after the deposition. The film F is passed round a drum 9 rotating in direction f9, the lower portion of which drum protrudes into the deposition chamber 5. The film F is passed around the drum 9 in such a way as to pass through the deposition chamber 5.

The chamber 7 is connected, by means of a pipe 11, to a suction pump which is not shown and which ensures a sufficient degree of pressure reduction in the said chamber 7. The chamber 5 is connected, by means of a coupling 13, to another pump, which is not shown and which ensures a sufficient level of vacuum in the said chamber 5.

In the chamber 5 is located a first evaporation source, generically indicated by 15. The source 15 is shown schematically in the form of an electron gun evaporation source. The electron gun is indicated schematically by 17 and is combined with means 19 for deflecting the electron beam which is directed towards the material to be evaporated, contained in a crucible 21. In the deposition chamber 5 there is furthermore located a second evaporation source 23, for example consisting of a crucible heated by resistance, by induction or by other means.

The deposition chamber 5 is connected to an oxygen source generically shown schematically at 25. Means indicated schematically by 29 for regulating the flow of oxygen into the deposition chamber 5 are provided on the pipe 27 which connects the source 25 to the interior of the chamber 5.

According to the invention, the oxide which tends to dissociate is evaporated in the evaporation source 21 and the getter metal is evaporated in the source 23. An application example, with numerical data relating thereto, is presented below.

### APPLICATION EXAMPLE

Silicon dioxide (SiO₂) and magnesium (Mg) are used as the deposition materials.

The process parameters are as follows:

| | |
|---|---|
| Film width | 1 m |
| Linear feed rate of the film | 5 m/sec |
| Thickness of the layer to be deposited | 100 nm (1000 Å) |
| Composition of the layer deposited | SiO_{1.5}+MgO |

66 g/min of SiO₂ and 13.2 g/min of Mg are required to obtain this layer. Since not all the material evaporated deposits on the film, if a utilization factor of 0.5 (defined as the ratio of material actually deposited on the plastic film to material evaporated) is assumed, 132 g/min of SiO₂ and 26.4 g/min of Mg are found to be necessary.

The pressure prevailing in the deposition chamber 5 must be of the order of 1·10⁻² Pascal.

The temperatures for the evaporation of SiO₂ are of the order of magnitude of 1400°C while the temperature for the evaporation of the magnesium is of the order of 600°C.

The composition of the layer of mixed oxides which is obtained can be represented approximately by the formula

SiO_{1.5}(MgO)_{0.5}

The process can be regulated as follows. Having fixed the thickness of the layer of mixed oxides which it is desired to deposit and having determined the speed of advance of the plastic film, the power of the electron gun 17 and the range of the oxygen from the source 25 are determined. The degree of vacuum in the deposition chamber 5 is determined by means of a pressure transducer shown schematically by 31. The temperature of the source 23 (from which the getter metal evaporates) is regulated so as to keep the degree of vacuum constant in the chamber 5. This is achieved by increasing the temperature of the source 23 when an increase in the pressure in the deposition chamber 5 is recorded. In effect, this increases the amount of getter metal evaporated and hence the amount of oxygen absorbed.

In order to achieve this regulating effect, a central processing unit, schematically indicated by 33, receives the data relating to the degree of vacuum from the sensor 31, and also the value of the temperature of the source 23 (from the line 35), and consequently controls the heating resistance 37 of the source 23.

In the attached drawing, the clouds of vapour emitted from the two sources are separate. This does not mean that the sources 21 and 23 cannot be adjacent so as to achieve a more or less extensive superposition of the said clouds.

Furthermore, the spatial arrangement of the sources 21 and 23 can be inverted so as to achieve a deposit with the reverse stratification.

In order to increase the efficiency of the metal source, the latter can be associated with a pair of radio frequency electrodes 38 which bring about an ionization of the cloud of vapours emitted from the source 23. In this way a plasma-assisted deposition is achieved.

Finally, as regards the choice of materials to evaporate, instead of silicon dioxide and magnesium, as in the embodiment illustrated above, other materials may be used, such as, for example, silica and aluminium. In that case, the crucible 23 will be replaced by a conventional system for the evaporation of aluminium, typically a small boat fed with Al metal wire and heated by the Joule effect. The electrodes 38 can be provided in this case also.

## Claims

1. A process for the production of a plastic film having a dielectric layer of mixed oxides deposited by vacuum deposition, characterized in that there is performed, on said plastic film, a co-deposition of a first material consisting of a sub-oxide resulting from the evaporation of a material consisting of an oxide which tends to dissociate liberating oxygen, and of a second material consisting of a metal oxide resulting from the reaction of a vaporized material consisting of a metal having a getter effect with the oxygen liberated by said first material, wherein said oxide tending to dissociate and said metal evaporate from two different sources.

2. Process according to Claim 1, characterized in that the said first material comprises silicon dioxide (SiO₂) or alumina (Al₂O₃).

3. Process according to Claim 1 or 2, characterized in that the said second material comprises magnesium, aluminium or barium.

4. Process according to one or more of Claims 1 to 3, characterized in that the said first material comprises silicon dioxide and the said second material comprises magnesium.

5. Process according to one or more of the preceding claims, characterized in that during the codeposition stage oxygen is added in a controlled amount, the said oxygen preventing the deposition of the said second material in the metallic state on the plastic film.

6. Process according to one or more of the preceding claims, characterized in that having fixed the speed of advance of the plastic film and the thickness of the thin layer of deposit, the deposition process is regulated by keeping the power of the oxide evaporation source constant and varying the temperature of the metal evaporation source as a function of the degree of vacuum in the deposition chamber.

7. An apparatus for performing the process of one or more of the preceding claims, including, in one and the same deposition chamber two separate sources of different materials, characterized in that said sources include a first source of a first material consisting of an oxide which tends to dissociate during evaporation, liberating oxygen, and a second source containing a second material consisting of a metal having a getter effect.

8. Apparatus according to Claim 7, characterized in that the said first source is an electron gun source.

9. Apparatus according to Claim 7 or 8, characterized in that the said second source is a resistance source.

10. Apparatus according to one or more of Claims 7 to 9, characterized in that it comprises an oxygen source for introducing controlled amounts of oxygen into the deposition chamber.

11. Apparatus according to one or more of Claims 7 to 10, characterized in that it comprises, in the deposition chamber, a sensor for determining the degree of vacuum, a sensor for determining the temperature of the source of evaporation of the second material and means, which can be regulated, of heating the said source of evaporation of the second material, and that it furthermore comprises a central unit which regulates the temperature of the said source of evaporation of the second material as a function of the degree of vacuum which has been determined.

## Patentansprüche

1. Verfahren für die Herstellung einer Kunststoffolie mit einer dielektrischen Schicht aus mittels Vakuumabscheidung abgeschiedenen Mischoxiden,
**dadurch gekennzeichnet**, daß auf der Kunststoffolie eine gemeinsame Abscheidung durchgeführt wird eines ersten Materials, welches aus einem Suboxid besteht, das sich aus der Verdampfung eines zu Dissoziierung unter Freisetzung von Sauerstoff neigenden Materials, das aus einem Oxid besteht, ergibt, und eines zweiten Materials, das aus einem Metalloxid besteht, das sich aus der Reaktion eines verdampften Materials, das aus einem Metall besteht, das einen Getter-Effekt hat, mit dem aus dem ersten Material freigesetzten Sauerstoff ergibt, wobei das zu Dissozierung neigende Oxid und das Metall aus zwei verschiedenen Quellen verdampfen.

2. Verfahren nach Anspruch 1,
**dadurch gekennzeichnet**, daß das erste Material Siliziumdioxid (SiO₂) oder Aluminiumoxid (Al₂O₃) umfaßt.

3. Verfahren nach Anspruch 1 oder 2,
**dadurch gekennzeichnet**, daß das zweite Material Magnesium, Aluminium oder Barium umfaßt.

4. Verfahren nach einem oder mehreren der Ansprüche 1 bis 3, **dadurch gekennzeichnet**, daß das erste Material Siliziumdioxid und das zweite Material Magnesium umfaßt.

5. Verfahren nach einem oder mehreren der vorangehenden Ansprüche, **dadurch gekennzeichnet**, daß während der gemeinsamen Abscheidungsstufe Sauerstoff in gesteuerter Menge hinzugefügt wird, wobei dieser Sauerstoff die Abscheidung des zweiten Materials im metallischen Zustand auf der Kunststoffolie verhindert.

6. Verfahren nach einem oder mehreren der vorangehenden Ansprüche, **dadurch gekennzeichnet**, daß nach Festlegung der Vorschubgeschwindigkeit der Kunststoffolie und der Dicke der dünnen Abscheidungsschicht der Abscheidungsprozeß in der Weise geregelt wird, daß die Leistung der Oxidverdampfungsquelle konstant gehalten und die Temperatur der Metallverdampfungsquelle in Abhängigkeit von der Höhe des Vakuums in der Abscheidungskammer verändert wird.

7. Vorrichtung zum Durchführen des Verfahrens nach einem oder mehreren der vorangehenden Ansprüche, die in ein und derselben Verdampfungskammer zwei getrennte Quellen für verschiedene Materialien enthält,
**dadurch gekennzeichnet**, daß die Quellen eine erste Quelle eines ersten Materials, das aus einem Oxid besteht, das bei der Verdampfung zur Dissoziierung unter Freisetzung von Sauerstoff neigt, und eine zweite Quelle umfassen, die ein zweites Material enthält, das aus einem Metall mit Getter-Effekt besteht.

8. Vorrichtung nach Anspruch 7,
**dadurch gekennzeichnet**, daß die erste Quelle eine Elektronenkanonenquelle ist.

9. Vorrichtung nach Anspruch 7 oder 8,
**dadurch gekennzeichnet**, daß die zweite Quelle eine Widerstandsquelle ist.

10. Vorrichtung nach einem oder mehreren der Ansprüche 7 bis 9, **dadurch gekennzeichnet**, daß sie eine Sauerstoffquelle zum Einführen gesteuerter Mengen von Sauerstoff in die Abscheidungskammer umfaßt.

11. Vorrichtung nach einem oder mehreren der Ansprüche 7 bis 10, **dadurch gekennzeichnet**, daß sie in der Abscheidungskammer einen Sensor zum Bestimmen der Höhe des Vakuums, einen Sensor zum Bestimmen der Temperatur der Verdampfungsquelle des zweiten Materials und eine regelbare Einrichtung zum Heizen der Verdampfungsquelle des zweiten Materials aufweist, und daß sie ferner eine Zentraleinheit umfaßt, die die Temperatur der Verdampfungsquelle des zweiten Materials in Abhängigkeit von der ermittelten Höhe des Vakuums regelt.

## Revendications

1. Procédé pour la production d'un film plastique ayant une couche diélectrique d'oxydes mélangés, déposés sous vide, caractérisé en ce que l'on effectue sur ce film plastique, une codéposition d'un premier matériau constitué par un sous-oxyde provenant de l'évaporation d'un matériau constitué par un oxyde qui tend à se dissocier en libérant de l'oxygène, et d'un second matériau constitué par un oxyde métallique provenant de la réaction d'un matériau constitué par un métal vaporisé à effet getter ou sorbeur avec l'oxygène libérée par le premier matériau, dans lequel ledit oxyde tendant à se dissocier et ledit métal s'évaporent depuis deux sources différentes.

2. Procédé selon la revendication 1, caractérisé en ce que le premier matériau comprend du dioxyde de silicium (SiO₂) ou de l'alumine (Al₂O₃).

3. Procédé selon la revendication 1 ou 2, caractérisé en ce que le second matériau comprend du magnésium, de l'aluminium ou du baryum.

4. Procédé selon l'une ou plusieurs des revendications 1 à 3, caractérisé en ce que le premier matériau comprend du dioxyde de silicium et le second matériau comprend du magnésium.

5. Procédé selon l'une ou plusieurs des revendications précédentes, caractérisé en ce que pendant l'étape de codéposition on ajoute de l'oxygène dans une quantité contrôlée, l'oxygène empêchant la déposition du second matériau à l'état métallique sur le film plastique.

6. Procédé selon l'une ou plusieurs des revendications précédentes, caractérisé en ce qu'après avoir fixé la vitesse d'avance du film plastique et l'épaisseur de la couche mince de dépôt, le procédé de déposition est régulé en maintenant constante la puissance de la source d'évaporation d'oxyde et en faisant varier la température de la source d'évaporation métallique en fonction du degré de vide dans la chambre de déposition.

7. Appareil pour la réalisation du procédé d'une ou plusieurs des revendications précédentes, comprenant dans une seule et même chambre de déposition deux sources séparées de matériaux différents, caractérisé en ce que les Sources comprennent une première source d'un premier matériau constitué par un oxyde qui tend à se dissocier pendant l'évaporation, libérant de l'oxygène, et une seconde source contenant un second matériau constitué par un métal ayant un effet getter ou sorbeur.

8. Appareil selon la revendication 7, caractérisé en ce que la première source est une source à canon d'électrons.

9. Appareil selon la revendication 7 ou 8, caractérisé en ce que la seconde source est une source de résistance.

10. Appareil selon l'une ou plusieurs des revendications 7 à 9, caractérisé en ce qu'il comprend une source d'oxygène pour l'introduction de quantités contrôlées d'oxygène dans la chambre de déposition.

11. Appareil selon l'une ou plusieurs des revendications 7 à 10, caractérisé en ce qu'il comprend, dans la chambre de déposition, un capteur pour déterminer le degré de vide, un capteur pour déterminer la température de la source d'évaporation du second matériau et des moyens, qui peuvent être régulés, pour chauffer la source d'évaporation du second matériau et qui comprend de plus une unité centrale qui régule la température de la source d'évaporation du second matériau en fonction du degré de vide qui a été déterminé.
